Europäisches Patentamt

European Patent Office

Office européen des brevets

(11) Veröffentlichungsnummer: **0 302 984**
**A1**

## (12) EUROPÄISCHE PATENTANMELDUNG

(21) Anmeldenummer: **87890188.3**

(22) Anmeldetag: **12.08.87**

(51) Int. Cl.⁴: **C23C 16/30 , C23C 30/00**

(43) Veröffentlichungstag der Anmeldung:
**15.02.89 Patentblatt 89/07**

(84) Benannte Vertragsstaaten:
**CH DE FR GB IT LI SE**

(71) Anmelder: **Pacher, Oskar, Dipl.-Ing. Dr.**
**Peter Tunnergasse 17**
**A-8605 Kapfenberg(AT)**

(72) Erfinder: **Pacher, Oskar, Dipl.-Ing. Dr.**
**Peter Tunnergasse 17**
**A-8605 Kapfenberg(AT)**

(54) **Beschichteter Hartmetallkörper.**

(57) Hartmetallkörper, insbesondere Hartmetallschneidwerkzeug mit einer, gegebenenfalls mehrlagigen, Sauerstoff und Aluminium enthaltender Beschichtung auf Basis von karbidischen und/oder nitridischen Hartstoffen mit Elementen der IV - VI Nebengruppe, wobei auf einem Substrat des Grundkörpers, eine erste sauerstoffaufweisende karbidische und/oder nitridische Beschichtung aufgebracht ist, auf welcher zumindest eine weitere oxidische und/oder nitridische Beschichtung mit Einlagerungen oder Ausscheidungen angeordnet ist, wobei die Einlagerungen bzw. Ausscheidungen aus Oxid und/oder Nitrid und/oder Karbid von Aluminium und/oder Zirkonium und/oder Titan bestehen, welche durch eine besondere Temperaturführung und/oder Gasführung bei der Beschichtung entstehen sowie Verfahren zu ihrer Herstellung.

TiN
Ti(O,N)+Al₂O₃ – Einlagerungen
Al₂O₃
Ti(C,N,O) – Einlagerungsschicht
TiC
TiN
Hartmetall

1μm 25 1kV 100E4 0183/50 SE

Fig. 1

EP 0 302 984 A1

## Beschichteter Hartmetallkörper

Die Erfindung betrifft einen beschichteten Hartmetallkörper, insbesondere ein beschichtetes Hartmetallschneidwerkzeug, wobei die Grundbeschichtung aus einer Sauerstoff und Aluminium enthaltenden Beschichtung auf der Basis von karbidischen und/oder nitridischen Hartstoffen, mit Elementen der IV - VI Nebengruppe des Periodensystems gebildet wird, und mindestens eine weitere Beschichtung auf Oxidbasis und/oder Nitridbasis trägt, welche Einlagerungen bzw. Ausscheidungen aus Oxid oder Nitrid von Aluminium und/oder Zirkon und/oder Titan aufweist sowie ein Verfahren zur Herstellung derselben.

Hartmetallkörper und Werkzeug wie oben angeführt werden unter anderem in der Metallverarbeitung eingesetzt und dienen insbesondere als Werkzeuge für das Drehen, Schneiden, Fräsen, Bohren, Sägen u. dgl., das spanlose Verformen, insbesondere im kalten Zustand des Werkstückes sowie als Matrizen, Düsen, Preßstempel, Gesenke u. dgl. Als Körper mit guten Verschleißeigenschaften, insbesondere für die Metallbearbeitung, sind Hartmetallgrundkörper, welche eine Beschichtung auch in mehrlagiger Ausführung tragen, bekannt, wobei immer das Bestreben besteht, daß die Werkzeuge sowohl den mechanischen Anforderungen standhalten als auch hohe Bearbeitungsleistungen erbringen. Somit sind alle Bestrebungen darauf ausgerichtet, die Standzeit der Werkzeuge durch einlagige oder mehrlagige Hartstoffschichten zu erhöhen.

Aus der DE-AS 22 53 745 ist beispielsweise ein Werkzeug bekannt, bei welchem auf eine Grundschicht eine äußere Schicht aus einer oder mehreren extrem verschleißfesten Ablagerungen, bestehend aus Aluminiumoxid und/oder Zirkonoxid aufgebracht ist. In diesen reinen und homogenen Oxidschichten kann es aufgrund unterschiedlicher thermischer Ausdehnungskoeffizienten zur Nachbarschicht zu Rissen kommen, wobei auch die ungenügende Haftfestigkeit und Sprödigkeit bei größer werdender Schichtdicke zu Abplatzungen führt, was sich nachteilig auf die Werkzeugstandzeit auswirkt.

In der DE-AS 29 17 349 ist ein Werkzeug mit 38 Einzelschichten beschrieben, wodurch Haftungsprobleme vermindert und die Verschleißfestigkeit verbessert werden sollen. Soweit zu derartigen Viellagenbeschichtungen Erfahrungen und Ergebnisse vorliegen, haben sich die an sie gestellten Erwartungen nicht erfüllt. Die Probleme der Schichthaftung, des Schichtverschleißes und der mechanischen Eigenschaften von Beschichtungen lassen sich durch eine Vervielfachung von Schichtfolgen offensichtlich nicht lösen.

Aus der EP-A1 0 083 043 ist ein mehrschichtiger Hartstoffüberzug mit verbesserter Haftfestigkeit bekannt geworden. Dabei wird unmittelbar über eine Unterlagschicht auf dem Grundkörper ein Überzug aus je einer oder mehreren Schichten von Oxikarbiden und/oder Oxikarbonitriden und/oder Oxinitriden und/oder Oxiboriden und/oder Oxibornitriden und/oder Oxiborkarbonitriden, jeweils im Wechsel mit einer oder mehreren Schichten von Aluminium-Bor-, Mischoxiden, aufgebracht. Durch diese Wechselschichten wird laut EP-A1 0 083 043 eine wesentlich erhöhte Verschleißfestigkeit sowie eine ausgezeichnete Haftfestigkeit der Hartstoffbeschichtung erreicht. Diese guten Eigenschaften ergeben sich aus dem Einbau von Bor in die Aluminiumoxid-Schichten bei gleichzeitigem Einbau von Sauerstoff-Anteilen in die Oxikarbid-, Oxikarbonitrid-, Oxinitrid-, Oxiborid-, Oxibornitrid- und Oxiborkarbonitrid-Zwischenschichten. Durch die Maßnahme des Einbaus der Sauerstoff-Anteile in den Zwischenschichten und des Bors in den Aluminiumoxidschichten werden die Grenzspannungen vermindert und die Haftfestigkeit verbessert. Nachteilig dabei ist, daß die extrem gute Verschleißfestigkeit von Ablagerungen aus Aluminiumoxid und/oder Zirkonoxid und/oder Titanoxid nicht erreicht wird.

Aus EP-A1 0 149 449 ist ein Hartmetallkörper, insbesondere ein Hartmetall-Schneidwerkzeug mit zwei Beschichtungen bekannt geworden, wobei in der zweiten oxidischen Beschichtung eine Schicht, gegebenenfalls boridhältige, Einlagerungen aufweisen kann. Diese gegebenenfalls vorgesehenen Einlagerungen haben zumindest wesentliche Anteile Metallborid und sind vorzugsweise aus Aluminium- und/oder Zirkoniumborid gebildet. Die Verschleißeigenschafts-Verbesserungen sollen dabei gemäß obiger EP-A1 durch den Einbau von Zirkon in die auf die erfindungsgemäß mit Aluminium dotierte Grundbeschichtung aufgebrachten oxidischen Überzüge erreicht werden, ebenso durch Einbau von Borid-Einlagerungen.

Der Erfindung liegt die Aufgabe zugrunde, Hartmetallkörper, insbesondere Harmetallschneidwerkzeuge, mit aus mehreren Schichten bestehender Beschichtung zu schaffen, welche eine gegenüber bekannten Verschleißteilen wesentlich verbesserte Haftfestigkeit und einen hohen Bruchwiderstand besitzt und gleichzeitig extrem verschleißfest ist.

Diese Aufgabe wird dadurch gelöst, daß auf einem Substrat des Hartmetallgrundkörpers eine ein- oder mehrlagige erste Sauerstoff aufweisende karbidische und/oder nitridische Beschichtung aufgebracht ist, über welche zumindest eine weitere oxidische und/oder nitridische Beschichtung mit Einlagerungen und/oder Ausscheidungen angeordnet ist, wobei die Einlagerungen bzw. Ausscheidungen aus Oxid und/oder Nitrid und/oder Karbid von Aluminium und/oder Zirkonium und/oder Titan bestehen, welche durch eine besondere Temperaturführung und/oder Gasführung bei der Beschichtung entstehen. Gegenüber den

2

bekannten mehrlagig beschichteten Werkzeugen weist der erfindungsgemäß beschichtete Hartmetallkörper eine extrem hohe Verschleißfestikeit bei ausgezeichneter Haftfestigkeit der Beschichtung auf, woraus wesentlich verbesserte Gebrauchseigenschaften z.B. des Schneidwerkzeuges resultieren.

Hartstoffschichten sind durchwegs homogen und können Mischkristalle bilden. Dies ist immer dann der Fall, wenn die Substituierbarkeit von Atomen im Schichtgitter gegeben ist. So erfolgt z.B. durch die Substituierbarkeit von Kohlenstoff, Stickstoff und Sauerstoff in TiC bzw. TiN bzw. TiO die Bildung von homogenen Schichten aus Titankarbonitrid - Ti(C,N) - bzw. Titanoxikarbonitrid -Ti(C,N,O).

Das Bestreben, homogene Hartstoffschichten herzustellen, basiert auch auf der allgemeinen und von der Fachwelt bestätigten Tatsache, daß Inhomogenitäten bzw. Ausscheidungen in Schichten zu einer Verschlechterung der mechanischen Eigenschaften, insbesondere zu einer Versprödung und zu vermehrter Rißbildung im Material führen.

Bei Überwindung dieses Vorurteiles tritt der völlig unerwartete Effekt ein, daß, wenn zumindest eine Schicht der zweiten Beschichtung inhomogen ist, d.h. Ausscheidungen und/oder Einlagerungen auf Basis von Oxiden und/oder Nitriden und/oder Karbiden der Elemente Aluminium und/oder Zirkonium und/oder Titan aufweist, sich bei wesentlich erhöhter Verschleißfestigkeit eine ausgezeichnete Haftfestigkeit der Hartstoffbeschichtung einstellt.

Einlagerungen und/oder Ausscheidungen in Schichten werden z.B. dadurch erzeugt, daß während der Beschichtung nach dem CVD-Verfahren spezielle Gasgemische unterschiedlicher Zusammensetzung intermittierend angewendet werden. Erfolgt auf einer homogenen Schicht durch Änderung des Gasgemisches das Abscheiden eines unterschiedlich zusammengesetzten Hartstoffes, so keimt dieser zuerst an energetisch bevorzugten Oberflächenstellen der Grundschicht unter Bildung von Körnern an. Wird nun, bevor diese Körner zu einer homogenen Deckschicht zusammenwachsen, das Gasgemisch wiederum geändert, so verbleiben diese Körner als Einlagerungen oder Ausscheidungen in der sich neuerlich bildenden Schicht als Inhomogenitäten. Während des Ankeimens und des Wachsens der Einlagerungen kann es vorteilhaft sein, durch ein Pulsieren des Gasstromes die Bedingungen für die Abscheidung zu verbessern.

Die Größe der Ausscheidungen bzw. der Einlagerungen kann auch über die Dauer des Gasangebotes und mittels der Temperaturführung beeinflußt werden. Besonders vorteilhaft sind Ausscheidungen kleiner 1 $\mu$m.

Die Bedingungen für das Wachsen der Ausscheidungen und/oder Einlagerungen können auch durch eine spezielle Tem peraturführung bzw. Hitzebehandlung, gegebenenfalls auch unter Anwendung von Druck vorteilhaft eingestellt werden, wozu auch beispielsweise eine Temperaturänderung während der Beschichtung, insbesondere eine Temperaturerhöhung auf über 1080°C zu zählen sind.

Die Erfindung wird nachfolgend an Hand von Beispielen näher beschrieben. Die Zusammensetzungen der verwendeten Beschichtungsgase sind in Tabelle 1 zusammengefaßt.

Tabelle 1

| | |
|---|---|
| Beschichtungsgas:<br>A1 | 4 Vol % $TiCl_4$<br>56 Vol % $H_2$<br>40 Vol % $N_2$ |
| Beschichtungsgas:<br>A2 | 4 Vol %. $TiCl_4$<br>0,1 Vol % $CO_2$<br>40 Vol % $N_2$<br>Rest $H_2$ |
| Beschichtungsgas:<br>B1 | 3,5 Vol % $TiCl_4$<br>9 Vol % $CH_4$<br>Rest $H_2$ |
| Beschichtungsgas:<br>B2 | 4,5 Vol % $TiCl_4$<br>5,5 Vol % $CH_4$<br>15 Vol % $N_2$<br>Rest $H_2$ |
| Beschichtungsgas:<br>B3 | 4,5 Vol % $TiCl_4$<br>2 Vol % $CH_4$<br>18 Vol % $N_2$<br>0,1 Vol % $CO_2$<br>Rest $H_2$ |
| Beschichtungsgas:<br>C1 | 2,5 Vol % $AlCl_3$<br>4,5 Vol % $CO_2$<br>40 Vol % $H_2$<br>Rest $N_2$ |

Beispiel 1:

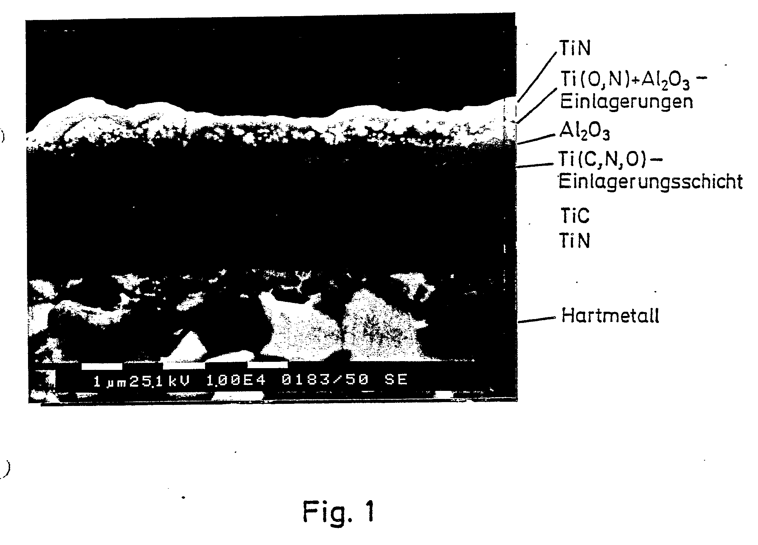

Wendeschneidplatten aus Hartmetall der ISO-Bezeichnung SPGN 12 04 08 bestehend aus 6,5 % Co, 3 % TiC + TaC, Rest WC wurden nach einer Reinigung in Aceton in einer CVD -Beschichtungsanlage unter Schutzgas auf 1020°C aufgeheizt. Nach Erreichung der Temperatur wurde während einer Zeit von 10 Minuten mit einem Gasgemisch der Zusammensetzung A1, und daran anschließend während einer Zeit von 18 Minuten mit einem Gasgemisch der Zusammensetzung B1, und daran anschließend während einer Zeit von 5 Minuten mit einem Gasgemisch B3 mit Zusatz von $AlCl_3$ Gas und daran unmittelbar wieder anschließend für weitere 20 Minuten mit einem Gasgemisch der Zusammensetzung C1 beschichtet. Auf diese Schicht wurde nach Steigerung der Temperatur auf 1050°C während einer Zeit von 21 Minuten mit einem Gasgemisch der Zusammensetzung A2 beschichtet, wobei das Beschichtungsgas 3 mal für die Zeitdauer von jeweils 2 Minuten mit einem Gasgemisch der Zusammensetzung C1 angereichert wurde, wodurch eine Titanoxinitridschicht mit aluminium- und sauerstoffhältigen Einlagerungen erhalten wurde. Nach dieser Beschichtung wurde abschließend während einer Dauer von 10 Minuten mit dem Gasgemisch A2 beschichtet.
Die erhaltene Beschichtung weist nitridische und karbidische Unterlagsschichten auf, gefolgt von einer stickstoff-, kohlenstoff-, sauerstoff- und aluminiumhältigen Oxinitrideinlagerungsschicht und einer darüber befindlichen ca. 1 $\mu$m dicken Schicht aus $Al_2O_3$ mit einer wiederum ca. 3,5 $\mu$m dicken Deckschicht bestehend aus Titanoxinitrid, die in ihrer Schichtmitte Ausscheidungen aus Aluminiumoxid enthält und eine ca. 0,5 $\mu$m dicke Deckschicht, vorwiegend aus TiN. Die durchschnittliche Teilchengröße der Ausscheidungen ist kleiner 0,2 $\mu$m. Das Bild in Fig. 1 zeigt eine elektronenmikroskopische Aufnahme eines Schnittes durch den beschichteten Körper.

Beispiel 2:

Wendeschneidplatten der gleichen Zusammensetzung wie in Beispiel 1 wurden bei einer Temperatur vn 1020°C während einer Zeit von 10 Minuten unter Verwendung des Gasgemisches A2 beschichtet und anschließend, nach Erhöhung der Temperatur auf 1050°C während eines Zeitraumes von 40 Minuten mit dem Gasgemisch B3 beschichtet. Während dieser Beschichtung wurde in regelmäßigen Abständen zusätzlicher Stickstoff eingeleitet und kurzzeitig die Gaskonzentration auf die Zusammensetzung A1 umgestellt, wodurch Einlagerungen bzw. Ausscheidungen bestehend aus TiN erhalten wurden. An diese Beschichtung anschließend wurde jeweils 2 mal während einer Zeit von 20 Minuten mit den Gasgemischen C1 und A1 beschichtet.

Die erhaltene Beschichtung besteht aus einer Unterlagsschicht aus Titanoxinitrid mit einer darüber befindlichen, ca. 4,5 μm dicken Oxikarbonitridschicht, die ihrerseits Einlagerungen aus TiN enthält. Die nachfolgenden äußeren Schichten bestehen aus $Al_2O_3$ und TiN.

Beispiel 3:

Wendeschneidplatten wurden bei 1020°C unter Verwendung des Gasgemisches A1 während einer Zeitdauer von 10 Minuten beschichtet. Nach dieser Beschichtung wurde während einer Zeitdauer von 20 Minuten mit einem Gasgemisch der Zusammensetzung B3 beschichtet, wobei gegen Ende dieser Beschichtung die Temperatur kontinuierlich auf 1060°C erhöht wurde. An diese Beschichtung anschließend wurde während einer Zeitdauer von 5 Minuten eine Haftzwischenschicht abgeschieden, wobei kontinuierlich die Gaszusam mensetzung von B2 und C1 verändert wurde. Daran anschließend wurde während einer Zeit von 20 Minuten 2 mal mit den Gasgemischen C1 und B2 beschichtet. Die so erhaltenen beschichteten Wendeschneidplatten weisen eine mehrschichtige Hartstoffbeschichtung mit Schichtausscheidungen und Schichteinlagerungen auf.

Tabelle 2

| ZERSPANUNGSBEDINGUNGEN | | |
|---|---|---|
| Werkstoff | Stahl: DIN Nr. 1.6582 vergütet auf 760-790 N/mm | Guß: GG 35 |
| Schnittgeschwindigkeit | 320 m/min | 180 m/min |
| Vorschub | 0,3 mm/Umdr. | 0,4 mm/Umdr. |
| Schnittiefe | 3 mm | 3 mm |

Tabelle 3

| ZERSPANUNGSERGEBNISSE | | |
|---|---|---|
| | Standzeitkriterium | |
| | VB = 0,4 mm Stahlzerspanung | VB = 0,7 mm Gußzerspanung |
| Beispiel 1 | 9 min | 22 min |
| Beispiel 2 | 10 min | 18 min |
| Beispiel 3 | 11 min | 21 min |
| Beispiel 4 (*) | 5 min | 3 min |

Beispiel 4 (*) ist eine dem Stand der Technik entsprechende marktübliche Mehrfachbeschichtung bestehend aus den Schichten TiC, Ti(C,N), TiN, $Al_2O_3$, TiN, die als Vergleich herangezogen wurde.

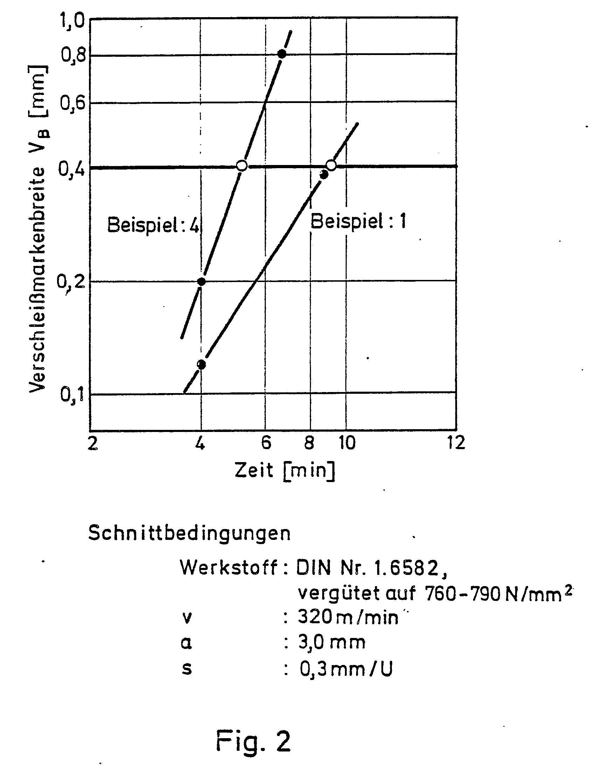

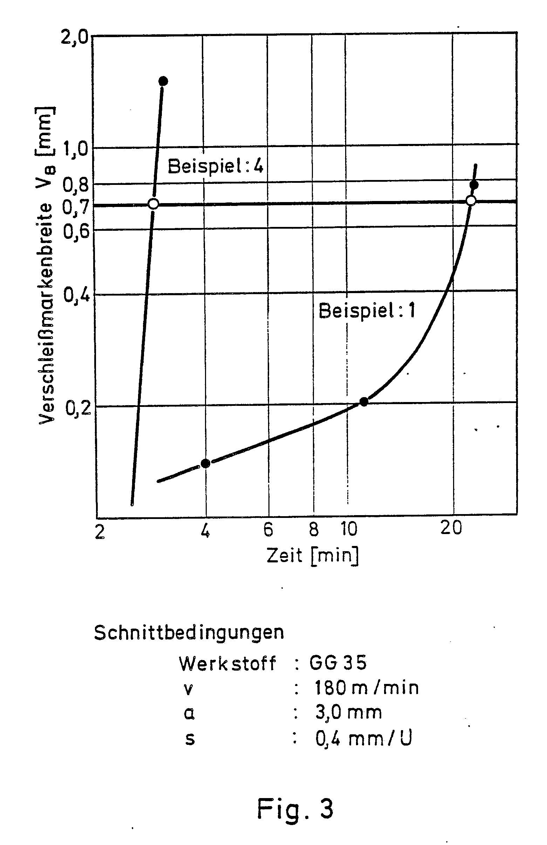

In Fig. 2 und Fig. 3 sind auf der Basis gleicher Verschleißmarkenbreite die Ergebnisse der Standzeiten eines erfindungsgemäß (Beispiel 1) beschichteten Werkzeuges, einem marktüblichen Werkzeug mit Mehrfachbeschichtung, gegenübergestellt.

## Ansprüche

1. Hartmetallkörper, insbesondere Hartmetallschneidwerkzeug mit einer, gegebenenfalls mehrlagigen, Sauerstoff und Aluminium enthaltender Beschichtung auf Basis von karbidischen und/oder nitridischen Hartstoffen mit Elementen der IV - VI Nebengruppe, wobei auf einem Substrat des Grundkörpers, eine erste sauerstoffaufweisende karbidische und/oder nitridische Beschichtung mit zumindestens einer 0,1 bis 2,5 Atom-% Aluminium aufweisenden Schicht, aus Oxikarbonitrid oder Oxinitrid, zumindest eines der Elemente Titan, Zirkon,Hafnium, Vanadin, Niob, Tantal und Chrom und/oder mit Oxikarbid zumindest eines der Elemente Titan, Zirkon, Hafnium und Chrom aufgebracht ist, und daß zumindest eine weitere oxidische und/oder nitridische Beschichtung mit Einlagerungen oder Ausscheidungen angeordnet ist, wobei die Einlagerungen bzw. Ausscheidungen aus Oxid und/oder Nitrid und/oder Karbid von Aluminium und/oder Zirkonium und/oder Titan bestehen, welche durch eine besondere Temperaturführung und/oder Gasführung bei der Beschichtung entstehen.

2. Hartmetallkörper nach Anspruch 1, dadurch gekennzeichnet, daß die in mindestens einer Schicht der zweiten Beschichtung vorhandenen sauerstoffhältigen Einlagerungen durch Oxide des Aluminiums gebildet sind.

3. Hartmetallkörper nach Anspruch 1, dadurch gekennzeichnet, daß die in mindestens einer Schicht der zweiten Beschichtung vorhandenen stickstoffhältigen Einlagerungen durch Nitride des Titans gebildet sind.

4. Verfahren zur Herstellung eines Hartmetallkörpers nach einem der Ansprüche 1 bis 3, wobei auf einem, vorzugsweise Tantal enthaltenden Substrat des Grundkörpers nach einem Gasphasen-Abscheidungs-Verfahren (CVD-Verfahren) in Gegenwart einer Sauerstoff und/oder Stickstoff und Aluminium, in gegebenenfalls sich während des Beschichtungsvorganges ändernden Mengen, enthaltenden bzw. liefernden, zumindest eines der in Anspruch 1 genannten Metalle in Form entsprechender Verbindungen aufweisenden Gasphase eine erste Beschichtung mit zumindest einer Schicht mit Oxikarbid, Oxikarbonitrid oder Oxinitrid, welche zumindest eines der im Anspruch 1 genannten Metalle aufweist, aufgebracht wird, und daß in Gegenwart einer Aluminium und/oder Zirkonium und/oder Titan, sowie Kohlenstoff und/oder Stickstoff und/oder Sauerstoff, in während des Beschichtungsvorganges sich ändernden Mengen, enthaltenden Gasphase eine zweite Beschichtung mit zumindest einer, oxidische und/oder nitridische und/oder karbidische Einlagerungen bzw. Ausscheidungen enthaltenden Schicht abgeschieden wird.

5. Verfahren nach Anspruch 4, dadurch gekennzeichnet, daß die die Beschichtung bewirkenden bzw. liefernden Gasgemische intermittierend angewendet werden.

6. Verfahren nach den Ansprüchen 4 und 5, dadurch gekennzeichnet, daß ein für eine Schicht der zweiten Beschichtung eingesetztes Gasgemisch unmittelbar nach dem Beginn der Schichtbildung, d.h. nach der Ablagerung von unzusammenhängenden Körnern auf energetisch bevorzugten Oberflächenstellen der vorliegenden Schicht, in seiner chemischen Zusammensetzung geändert wird.

7. Verfahren nach den Ansprüchen 4 bis 6, dadurch gekenn zeichnet, daß unmittelbar nach der Ablagerung von Körnern das Gasgemisch in seiner chemischen Zusammensetzung geändert wird, worauf die Einlagerungs- und Ausscheidungskörner durch eine entsprechend vom geänderten Gasgemisch bewirkte bzw. gelieferte homogene Schicht abgedeckt werden.

8. Verfahren nach den Ansprüchen 4 bis 7, dadurch gekennzeichnet, daß Einlagerungen und Ausscheidungen mit einer Größe von kleiner 5 μm, vorzugsweise kleiner 2 μm, gebildet werden.

9. Verfahren nach den Ansprüchen 4 bis 8, dadurch gekennzeichnet, daß mehrere Schichten mit Einlagerungen bzw. Ausscheidungen mit jeweils homogenen Zwischenschichten gebildet werden.

10. Verfahren nach einem oder mehreren der Ansprüche 4 bis 9, dadurch gekennzeichnet, daß während der Beschichtung eine Temperaturänderung, vorzugsweise eine Temperaturerhöhung auf höher als 1080°C, angewendet wird.

11. Verfahren nach einem oder mehreren der Ansprüche 4 bis 10, dadurch gekennzeichnet, daß während des Beschichtungsvorganges das(die) Gasgemisch(e) pulsierend zugeleitet wird(werden).

TiN

Ti(O,N)+Al$_2$O$_3$ –
Einlagerungen

Al$_2$O$_3$

Ti(C,N,O) –
Einlagerungsschicht

TiC
TiN

Hartmetall

1 µm 25,1 kV 1,00E4 0183/50 SE

Fig. 1

Schnittbedingungen

Werkstoff: DIN Nr. 1.6582,
         vergütet auf 760-790 N/mm²
v       : 320 m/min
a       : 3,0 mm
s       : 0,3 mm/U

Fig. 2

Fig. 3

**Schnittbedingungen**

Werkstoff : GG 35
v : 180 m/min
a : 3,0 mm
s : 0,4 mm/U

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A,D | EP-A-0 149 449  (VEREINIGTE EDELSTAHLWERKE)<br>* Ansprüche 1,14 *<br>--- | 1,4,9 | C 23 C  16/30<br>C 23 C  30/00 |
| A | DE-A-2 736 982  (F. KRUPP)<br>* Ansprüche 1,3,4; Seite 6, Zeile 29 - Seite 7, Zeile 8 *<br>--- | 1,4 | |
| A,D | EP-A-0 083 043  (METALLWERK PLANSEE)<br>--- | | |
| A,D | DE-A-2 253 745  (SANDVIK)<br>----- | | |

| RECHERCHIERTE SACHGEBIETE (Int. Cl.4) |
|---|
| C 23 C |

Der vorliegende Recherchenbericht wurde für alle Patentansprüche erstellt

| Recherchenort | Abschlußdatum der Recherche | Prüfer |
|---|---|---|
| DEN HAAG | 11-04-1988 | PATTERSON A.M. |